Europäisches Patentamt

(19) European Patent Office

Office européen des brevets

(11) **EP 0 438 357 B1**

(12) **FASCICULE DE BREVET EUROPEEN**

(45) Date de publication et mention
de la délivrance du brevet:
**14.08.1996 Bulletin 1996/33**

(51) Int. Cl.[6]: **C03C 17/09**, C03C 17/36,
C23C 14/18

(21) Numéro de dépôt: **91400103.7**

(22) Date de dépôt: **18.01.1991**

(54) **Couche mince pour vitrage de protection solaire**

Dünnschicht für Sonnenschutzverglasung

Thin film for solar protection glazing

(84) Etats contractants désignés:
**BE DE ES FR GB IT LU NL SE**

(30) Priorité: **19.01.1990 FR 9000593**

(43) Date de publication de la demande:
**24.07.1991 Bulletin 1991/30**

(73) Titulaire: **SAINT-GOBAIN VITRAGE**
**F-92400 Courbevoie (FR)**

(72) Inventeurs:
• **Tabare, Jacques**
**F-95590 Presles (FR)**
• **Termath, Guenther**
**W-4650 Gelsenkirchen (DE)**
• **Wuest, Isabelle**
**F-75011 Paris (FR)**
• **Anderson, Charles Edward**
**F-92400 Courbevoie (FR)**

(74) Mandataire: **Breton, Jean-Claude et al**
**SAINT-GOBAIN RECHERCHE**
**39, quai Lucien Lefranc**
**93300 Aubervilliers Cedex (FR)**

(56) Documents cités:
**FR-A- 2 177 708      US-A- 4 773 717**

• **CHEMICAL ABSTRACTS, vol. 107, no. 10, 07
septembre 1987 Columbus, Ohio, USA page 303;
ref. no. 82664J & JP-A-62123403 (SHARP CORP.)
(04-06-1987)**
• **CHEMICAL ABSTRACTS, vol. 111, no. 2, 10
juillet 1989 Columbus, Ohio, USA page**
• **La version anglaise du document JP-A-62 123
403 (dossier pages 33-36) a été utilisée pour
l'analyse de la brevetabilité à la place de l'abrégé
cité dans le rapport de recherche.**

**Description**

L'invention concerne un vitrage monolithique équipé d'une couche mince. Le vitrage assure la protection solaire, il est plus particulièrement destiné à être installé sur des véhicules et spécialement des automobiles.

Les modèles les plus récents d'automobiles ont des vitrages dont la surface et souvent, l'inclinaison s'accroissent de plus en plus. L'énergie solaire susceptible de pénétrer à l'intérieur des habitacles est accrue en conséquence et le confort d'été des véhicules non équipés de climatisation est de plus en plus problématique. Un des moyens permettant d'améliorer la situation consiste à équiper les vitrages autres que le pare-brise d'une couche mince absorbant une partie importante des rayons solaires incidents. Il existe cependant des exigences rigoureuses pour de telles couches, elles doivent par exemple avoir un coefficient de réflexion limité, particulièrement vers l'extérieur. De même, leur résistance à la rayure et leur tenue à l'humidité doit être excellente. C'est sur ces trois critères que la couche de l'invention présente une amélioration déterminante par rapport aux couches existantes.

Le problème technique se posait dans les termes suivants : comment obtenir un vitrage recouvert d'une couche mince très absorbante et dont les performances de tenue à l'abrasion et à l'humidité soient pratiquement les mêmes que celles du verre seul ?

Parmi les techniques de dépôt de couches minces sur le verre, les plus courantes utilisent pour les unes, le dépôt chimique à haute température comme la pyrolyse ou le dépôt chimique en phase vapeur (CVD) et pour les autres, les dépôts sous vide. Avec les premières techniques, on est limité en général dans les performances des couches obtenues car les produits possèdent le plus souvent un rapport transmission de lumière visible/transmission infra-rouge trop petit ; en revanche, ces techniques à haute température ont l'avantage de fournir des couches très adhérentes, le plus souvent de bonne tenue à la rayure et très résistantes à l'humidité. Avec les couches sous-vide, les résultats sont différents puisqu'on maîtrise beaucoup mieux les performances optiques mais en revanche la tenue mécanique ou chimique des couches est nettement moins bonne que celle des couches pyrolysées ou obtenues par CVD.

Cependant, l'industrie automobile moderne a besoin de vitrages minces car ils doivent être légers mais il faut également qu'ils ne laissent passer qu'une faible partie de l'énergie solaire incidente comme par exemple moins de 30 % tout en étant assez transparents au rayonnement visible avec par exemple une transmission lumineuse de plus de 40 %. Il s'agit avec ces vitrages d'équiper l'arrière des véhicules en réalisant le concept dit "dark tail". Selon ce concept, on envisage d'avoir, sur un même véhicule, des vitrages dont la transmission serait décroissante par paliers du pare-brise (le plus transparent) aux vitrages latéraux avant puis aux vitrages latéraux arrière et enfin à la lunette arrière (la moins transparente), respectant ainsi l'exigence de visibilité maximum au travers du pare-brise (transmission lumineuse supérieure à 75% d'après les réglementations) mais renforçant le traitement anti-solaire sur les autres vitrages pour lesquels l'exigence en transmission est moins contraignante. Comme par ailleurs, pour des raisons de poids, on désire utiliser des verres dont l'épaisseur soit la plus faible possible, on aurait besoin dans le cas d'un verre coloré dans la masse, d'une part d'une coloration très dense et d'autre part de degrés de coloration différents (quatre dans l'exemple choisi ci-dessus). Ces deux exigences sont très difficiles à réaliser dans la pratique, jusqu'à présent il a été impossible de fabriquer des verres plats de qualité avec les coefficients d'absorption intrinsèques nécessaires. Ils sont en général limités à des transmissions énergétiques au minimum de l'ordre de 45 % en 4 mm d'épaisseur et ces transmissions sont trop importantes. C'est pourquoi, la seule solution est, éventuellement, en partant de ces verres-supports, de les équiper des couches les plus performantes, c'est-à-dire des couches sous vide qui fournissent le complément d'absorption nécessaire. Mais alors une exigence nouvelle se présente : celle liée à l'aspect du vitrage vu de l'extérieur, il est indispensable que cet aspect, de même qu'avec les verres absorbants traditionnels, soit aussi neutre que possible et qu'il varie peu sur les différents vitrages du "dark tail".

Des tentatives ont été faites en ce sens, c'est ainsi par exemple que la demande de brevet européen EP 0 374 000 A prévoit de recouvrir le verre d'une couche de carbure de titane TiC recouverte elle-même d'une surcouche d'oxyde d'indium-étain ITO. Cette combinaison assure parfaitement sa fonction de protection solaire. Cependant, l'aspect en réflexion peut encore être amélioré et la couche possède une adhérence sur le verre encore, elle aussi, susceptible d'amélioration. De plus, les tenues à l'humidité et à l'abrasion qui sont très bonnes n'atteignent néanmoins pas celles du verre de base.

Il est connu d'utiliser le tantale pour le déposer sur le verre. C'est ainsi que le brevet US 4 773 717 décrit un vitrage qui possède en réflexion des couleurs brillantes, avec un facteur de pureté élevé, l'effet coloré étant obtenu grâce à la combinaison d'une couche de métal et d'une couche interférentielle épaisse déposée par dessus. Parmi les 9 métaux cités pour la couche métallique, le tantale est mentionné.

Dans le brevet japonais JP 62-123 403 qui ne concerne pas un vitrage, on propose d'utiliser le tantale comme métal pour constituer un miroir coloré, le métal étant protégé sur sa face arrière par une anodisation. L'ajustement de la tension d'anodisation permet de changer à volonté la couleur du miroir.

L'invention se propose de produire un vitrage destiné à équiper une automobile, en particulier, un véhicule répondant au concept de «dark tail», qui soit utilisable en simple vitrage, qui ait des propriétés compatibles avec l'utilisation comme vitrage automobile, en particulier, propriétés optiques en réflexion, tenue à l'abrasion et à l'humidité.

Selon l'invention, un vitrage de protection solaire à base de verte silico-sodo-calcique est recouvert d'au moins une couche mince et au plus deux couches minces caractérisé en ce que la couche au contact du verre est à base de tantale métallique avec au maximum une épaisseur de 30 nm et en ce que, lorsqu'elle est présente, l'antre couche a une épaisseur inférieure à 40 nm, et est constituée d'un moins un oxyde métallique.

Les techniques de dépôt sont de préférence la pulvérisation cathodique à confinement magnétique de plasma.

La couche de tantale a une épaisseur comprise entre 2 et 30 nm : entre 4,5 et 6,5 et de préférence 5 nm pour un vitrage latéral automobile et entre 22 et 28 nm pour un toit automobile.

Dans le cas où le tantale est recouvert d'une couche d'oxyde, il s'agit de l'oxyde d'un ou de plusieurs des métaux du groupe comprenant l'étain, l'indium, le zinc, l'autimoine, le cadmium et le tantale.

L'épaisseur de cette couche est supérieure à 10 nm et de préférence 12 nm. Les épaisseurs de la couche de tantale sont les mêmes que lorsqu'elle est seule. Le verte support est de préférence coloré, spécialement du type TSA, TSA++ ou TFA. Dans le cas d'un vitrage latéral, la transmission lumineuse est comprise entre 0,30 et 0,75 avec un rapport TE/TL inférieur à 0,70 et dans le cas du toit automobile, la transmission lumineuse est au maximum de 0,10.

L'invention, permet grâce à une simple couche métallique qui se dépose très rapidement, d'obtenir un vitrage dont la réflexion côté verre est du même ordre que celle du verre seul et qui résiste particulièrement bien à l'abrasion. Cette résistance à la rayure est encore améliorée si on recouvre le tantale d'une couche d'oxyde qui améliore de plus, sensiblement, la tenue à l'humidité.

L'invention permet également en utilisant les mêmes dispositifs, d'obtenir un vitrage de toit d'un aspect voisin et de même tenue.

La description et les figures permettront de comprendre le fonctionnement, la portée et les avantages de l'invention.

La figure 1 représente schématiquement la couche de tantale supportée par le verre.

Sur la figure 2, la couche de tantale est protégée par une couche d'oxyde.

La technique de dépôt de l'invention est de préférence la pulvérisation cathodique avec confinement magnétique du plasma telle qu'elle est décrite dans le brevet allemand DE 24 63 432 C2 ou dans le brevet US 4 116 806.

Exemple 1

Dans l'exemple qui suit, on dépose par une méthode qui utilise la technique du brevet DE 24 63 432 C2, une couche de tantale sur un verre absorbant. Il s'agit d'un verre float trempé thermiquement de 4 mm d'épaisseur du type dit "TSA++". Sa composition est traditionnelle, c'est-à-dire silico-sodo-calcique mais avec, comme oxydes colorés ajoutés à la composition, ceux de fer et de cobalt. La quantité de $Fe_2O_3$ est de 0,80 % en poids avec une proportion ions ferreux par rapport au fer total de 0,25, celle de CoO est de 4 ppm en poids.

Pour déposer le tantale avec la pulvérisation cathodique, on a utilisé une cible de métal à 99,8 % de Ta. Les dimensions de la cible étaient 21 x 9 cm. L'installation était une installation de laboratoire, la cathode qui portait la cible était fixe, l'échantillon de verre de 10 x 10 cm était supporté par un carrousel d'un diamètre de 35 cm qui le faisait passer périodiquement devant la cible. La distance minimum entre l'échantillon et la cible était 10 cm. Une gestion de gaz permettait de faire circuler dans l'enceinte divers gaz avec des débits définis.

Avant toute chose on a procédé à un effluvage qui purge l'installation et le substrat de tout dépôt, en particulier organique. Puis, on a commencé par introduire, alors que le substrat ne se trouvait pas à l'emplacement du plasma, de l'argon avec un débit de 20 $cm^3$/minute (volume mesuré dans les conditions normales de température et de pression CNTP). La tension sur la cathode était établie à un potentiel de -280 volts. On laissait alors fonctionner la pulvérisation cathodique pendant 30 minutes ce qui provoque le nettoyage de la cible et permet au système de se mettre en régime.

On a alors mis en marche le carrousel et fait passer l'échantillon devant la cible, le courant s'établit à 500 mA. L'échantillon mettait 6,5 secondes à effectuer son passage devant la cible.

A la sortie de l'installation de vide, on a mesuré l'épaisseur de la couche de tantale, elle était de 5 nm. L'échantillon a alors été évalué selon différents critères. Les uns concernent les performances optiques, les autres la tenue de la couche sur le verre. Les critères optiques retenus sont la transmission $T_L$ et la réflexion lumineuses (avec l'illuminant A), cette dernière mesurée soit du côté de la couche, $R_L$ (en général, la face qui sera à l'intérieur de l'automobile), soit du côté du verre-support, $R'_L$. On mesure également la transmission énergétique pour le rayonnement solaire $T_E$. On obtient ici les valeurs suivantes : $T_L$ = O,44, $R_L$ = O,16, $R'_L$ = O,O5 et $T_E$ = 0,29. Ces valeurs conviennent à l'application automobile, on voit en particulier que la transmission lumineuse est relativement importante par rapport à la transmission énergétique ($T_E/T_L$ = 0,66).

En ce qui concerne la tenue mécanique de la couche, l'essai est un essai d'abrasion effectué avec une machine de la Société Taber Instrument Corporation aux Etats-Unis, modèle 174 "Standard Abrasion Tester". Elle est équipée de meules CS10 F chargées à 500 grammes.

L'échantillon est soumis à 1000 rotations, on mesure sa transmission lumineuse globale x à l'aide d'une sphère intégrante avant (τo) et après (τ1000) abrasion. Une troisième valeur sert de référence : la transmission du verre sans couche : τv. L'usure à l'abrasion est mesurée par la grandeur U :

$$U = \frac{\tau 1000 - \tau o}{\tau v - \tau o}$$

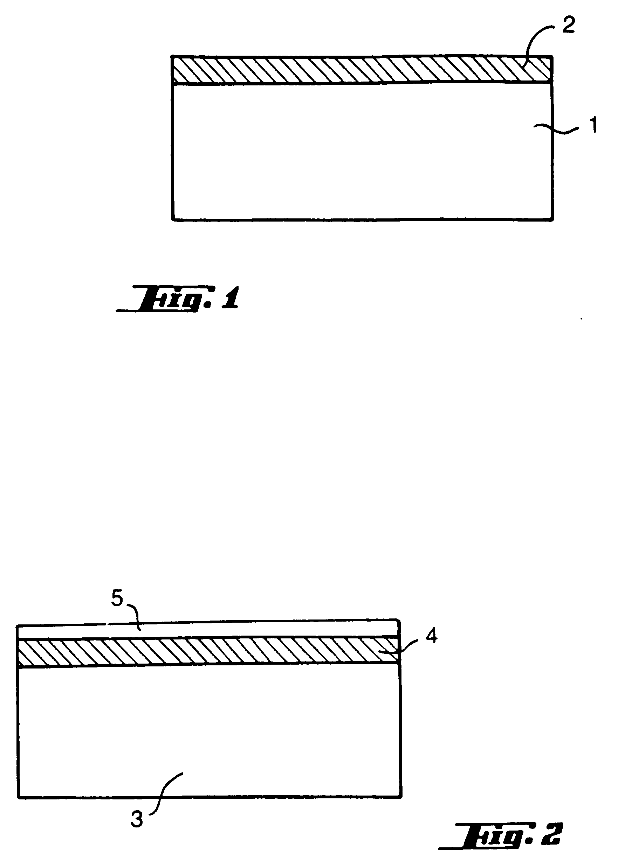

La couche représentée en 2 sur la figure 1, au-dessus du verre substrat 1, testée dans les conditions précédentes, a montré une valeur de l'«usure» U de 0,02. Ceci est particulièrement faible. En effet, des couches préconisées pour le même usage et à base de métaux de numéro atomique compris entre 22 et 28 montrent dans les mêmes conditions malgré leur protection par un oxyde métallique, une « usure » de 0,40. De même, en comparant cette valeur 0,02 avec le meilleur résultat obtenu avec des couches de carbure de titane protégées par de l'oxyde d'indium-étain telles que décrites dans la demande de brevet française 2 640 257 qui étaient pourtant très bonnes, on constate que leur usure reste néanmoins supérieure à 0,06.

Pour la tenue à l'humidité, on a utilisé la procédure du règlement R43 édicté par l'« Economic Commission for Europ » de Genève. Il s'agit de faire séjourner l'échantillon pendant deux semaines dans une ambiance à 50°C et 95% d'humidité relative. L'évaluation prévue par le Règlement se fait à l'oeil, il faut qu'après le test on ne voie aucune trace de dégradation. C'est le cas avec la couche de la figure 1. Cependant pour faire une évaluation plus précise, on a fait une comparaison avec un même échantillon avant et après le test en utilisant la même sphère intégrante que ci-dessus. On a ainsi défini un coefficient de dégradation D qui a la valeur suivante :

$$D = \frac{\tau H - \tau o}{\tau v - \tau o}$$

où $\tau H$ est la transmission globale de l'échantillon à couche à la fin du test, $\tau_o$ cette même grandeur au début du test et $\tau_v$ la transmission du verre sans couche.

Dans le cas du vitrage de la figure 1, recouvert de tantale, cette "dégradation" est de 0,15.

Le test à l'humidité évalué selon le mode précédent montre donc que malgré le résultat considéré comme "bon" selon le Règlement R43, il existe une certaine dégradation. C'est pour améliorer celle-ci qu'on a recouvert la couche de tantale d'une couche dure protectrice.

Exemple 2

Sur la figure 2, on voit un substrat 3 en verre coloré analogue au verre 1 de la figure 1. Il est lui aussi recouvert d'une couche de tantale 4 mais, le métal est ici recouvert d'une couche supplémentaire à base d'un oxyde métallique 5.

Cette couche supplémentaire est déposée par exemple par une technique de pulvérisation cathodique réactive. Sur la même installation de laboratoire, décrite ci-dessus, on a placé une seconde cathode en plus de la cathode équipée de la cible de tantale précédente. La cible de celle-ci est dans le cas de l'exemple en étain pur (à 99,9 %).

Le processus de dépôt s'effectue de la manière suivante : après avoir introduit dans l'enceinte un échantillon de verre coloré en tout point identique à celui de premier exemple, on referme l'installation et on y fait le vide. Après effluvage et purge de l'installation à l'argon avec un débit de 20 cm$^3$/mn CNTP d'argon, on met la cathode sous une tension de - 280 volt pendant 30 minutes. Puis le dépôt de tantale est effectué comme dans le premier cas.

Le dépôt de la couche d'oxyde commence lui aussi par un "pre-sputtering" pendant lequel on fait circuler un mélange d'argon et d'oxygène (15 % d'oxygène) avec un débit de 20 cm$^3$/mn CNTP. Une pression de 1,30 Pascal s'établit puis l'on met la cathode sous une tension de -300 volt. Pendant cette opération préliminaire, le verre est à l'abri. Après plusieurs dizaines de minutes, on met le carrousel en mouvement. Pendant le dépôt, le courant s'établit à 300 mA. La vitesse de rotation du carrousel est telle qu'il lui faut 3 minutes pour effectuer une rotation. Au bout d'un tour, on arrête le dépôt. La couche de SnO$_2$ a alors une épaisseur de 12 nm.

L'échantillon ainsi réalisé est soumis aux mêmes tests que précédemment.

Les résultats sont les suivants :

| | |
|---|---|
| $T_L$ | = 0,43 |
| $R_L$ | = O,16 |
| $R'_L$ | = 0,06 |
| $T_E$ | = 0,28 |
| U | = 0,O2 |
| D | = 0,OO |

On voit ainsi que les valeurs optiques restent pratiquement les mêmes qu'avec la couche de tantale seule. Ici aussi TE/TL avec une valeur de 0,65 constitue un bon indice de performance. La valeur pour l'abrasion reste également voisine. Quant à la valeur de la dégradation à l'humidité, elle est remarquable : aucun signe d'évolution n'est perceptible après deux semaines en humidité saturante à 50°C.

Une telle couche peut être déposée sur une installation industrielle de grandes dimensions et elle permet alors de fabriquer des vitrages destinés au bâtiment et qui possèdent une réflexion lumineuse faible et de ton neutre, particulièrement recherchée dans les constructions modernes.

Exemple 3

Comme pour l'exemple 1, sur la même installation, on utilise une cible unique en tantale. L'échantillon de verre est également du type "TSA++" comme dans l'exemple 1.

Ici le temps de dépôt de la couche de tantale pur est porté à 12 secondes ce qui fournit une couche sensiblement plus épaisse et donc plus absorbante. Par ailleurs on utilise la même cible pour réaliser un dépôt d'oxyde de tantale de type réactif, c'est à dire en ajoutant à l'argon plasmagène, de l'oxygène dans une proportion de 15%. Le débit global reste de 20 cm3/mn CNTP. La vitesse de rotation du carrousel était ici de quatre minutes pour un tour. On effectue un seul passage devant la cible. L'analyse des couches a montré qu'on avait une couche de tantale métallique de 9nm d'épaisseur à laquelle se superposait une couche d'oxyde de 12 nm. On a ainsi obtenu un échantillon dont les caractéristiques sont les suivantes :

$T_L$ = 0,35
$R_L$ = 0,19
$R'_L$ = 0,10
$T_E$ = 0,24
$T_E/T_L$ = 0,69

On a de plus effectué une mesure de la couleur en transmission et en réflexion coté verre pour la comparer à celle d'un échantillon de verre coloré du tue TSA++. En effet, lorsqu'on veut réaliser le concept "dark tail" sur une automobile, il est essentiel que les aspects des vitrages différents qui se succèdent de l'avant vers l'arrière du véhicule ne soient pas trop éloignés les uns des autres. Ce paramètre joue spécialement en réflexion du côté du verre puisque c'est cette caractéristique qui donnera l'impression globale du véhicule. Il importe que l'intensité de la réflexion et la couleur restent voisines. En plus de la grandeur $R'_L$ déjà citée on a mesuré la longueur d'onde dominante $'_D$(nm) et le facteur de pureté P'(%). En transmission, on est évidemment contraint d'accepter une évolution de la transmission lumineuse $T_L$ qui évolue obligatoirement avec la transmission énergétique $T_E$ qui par principe diminue de l'avant vers l'arrière du véhicule avec "dark tail" mais la couleur, caractérisée par $_D$ et P doit elle aussi ne pas changer trop d'un vitrage à son voisin. Les résultats comparés du vitrage de l'exemple 3 destiné à constituer par exemple un vitrage latéral arrière, comparé au verre TSA++ de 3 mm sans couche qui équipera, lui, la portière avant, sont les suivants :

| | $R'_L$ | $'_D$ | P' | $T_L$ | $_D$ | P |
|---|---|---|---|---|---|---|
| $TSA^{++}+Ta+Ta_2O_5$ | 0,10 | 486 | 10 | 0,35 | 594 | 4 |
| $TSA^{++}$ | 0,07 | 491 | 3,5 | 0,74 | 503 | 2,5 |

Ces résultats montrent que l'accord est très bon puisqu'en réflexion, la couleur est exactement la même, le coefficient de réflexion très peu différent et que le facteur de pureté reste limité. En transmission, avec une pureté très faible ($\leqq$ 4%) la teinte reste neutre malgré l'évolution sensible de la dominante.

Exemple 4

A la différence des précédents, le vitrage de l'exemple 4 n'est pas destiné à équiper les latéraux ou la lunette arrière d'une automobile à "dark tail", mais à constituer un toit transparent.

Il est réalisé à partir du même verre de base et dans la même installation que celui de l'exemple 3 mais avec des réglages différents.

La couche métallique en tantale est beaucoup plus épaisse ici (25 nm) mais la couche protectrice en $Ta_2O_5$ est la même : 12 nm.

Les caractéristiques sont :

$T_L$ = 0,09
$R_L$ = 0,43
$R'_L$ = 0,30
$T_E$ = 0,07

$\lambda'_D$ = 493 nm
P' = 7%
$\lambda_D$ = 487 nm
P = 7%

En dehors d'une réflexion nettement supérieure, l'aspect extérieur (la couleur) est très voisin de celui du verre simple.

Exemple 5

On prend un échantillon de verre flotté clair standard d'une épaisseur de 4 mm. Cet échantillon est introduit dans l'installation de pulvérisation cathodique à magnétron de l'exemple 1.

Avec la même cible de tantale que précédemment on effectue un dépôt dans les mêmes conditions (- 280 volts, 5OO mA), la durée du dépôt est également identique.

Une fois le dépôt de tantale terminé, l'échantillon est sorti de l'installation de pulvérisation cathodique pour être introduit dans une installation de dépôt chimique en phase vapeur (CVD). La méthode utilisée est classique, c'est par exemple celle qui est décrite dans la demande de brevet EP 335 769. On porte l'échantillon à une température de 250°C et on introduit dans l'enceinte un mélange d'argon, d'oxygène et de diéthylzinc avec les débits suivants :

1,3 cm$^3$/mn de $(C_2H_5)_2Zn$
600 cm$^3$/mn d'argon
et 13 cm$^3$/mn d'oxygène

La pression dans l'enceinte est de 13000 Pascals. Au bout de 60 secondes on arrête le dépôt. A sa sortie de l'enceinte, on mesure les caractéristiques optiques de l'échantillon.

L'épaisseur des couches successives est de 5,5 nanomètres pour le tantale et de 12 nanomètres pour l'oxyde de zinc. Les caractéristiques optiques sont les suivantes :

$T_L$ = O,35
$T_E$ = 0,40
$R_L$ = 0,24
$R'_L$ = 0,11

Les exemples qui précèdent utilisent comme supports destinés à recevoir les couches de l'invention, un verre clair standard pour le cinquième et un verre vert très coloré du type TSA++ pour les quatre premiers. Mais les résultats sont tout aussi satisfaisants avec les verres utilisés classiquement pour réaliser les vitrages automobiles tel que celui dit "TSA standard" qui est également vert et dont la composition chimique est celle d'un verre flotté silico-sodo-calcique mais avec une quantité de $Fe_2O_3$ de O,57 % en poids, avec une proportion d'ions ferreux par rapport au fer total de 0,25 %. Le verre bronze dit TSA tel qu'il est décrit dans les brevets FR 2 295 328 et 2 330 556 constitue également un excellent support pour les couches de l'invention.

Des cinq exemples qui précèdent, les quatre premiers utilisent des méthodes de pulvérisation cathodique et le cinquième combine cette même méthode avec la CVD. Mais d'autres méthodes sous-vide ou chimiques peuvent aussi bien être utilisées. Ainsi la couche de tantale peut être déposée par évaporation sous vide (thermique ou au canon à électrons) quant aux couches protectrices en dehors de la pulvérisation cathodique réactive, et de la CVD déjà citées, on peut utiliser la pulvérisation cathodique non réactive - par exemple à partir d'une cible d'ITO fritté - ou bien une technique de plasma-CVD analogue à celle décrite dans le brevet EP 230 180. Cependant dans le cas où le tantale est déposé par une technique de pulvérisation cathodique, comme par exemple avec confinement magnétique d'un plasma d'argon, la même technique avec la même cible mais en pulvérisation réactive en présence d'oxygène permet de déposer une surcouche d'oxyde de tantale dans des conditions particulièrement simples.

Ainsi les vitrages conformes à l'invention permettent de disposer de couches qui diminuent sensiblement la transmission énergétique d'un monovitrage tout en ayant un aspect voisin en réflexion de celui des autres vitrages d'un véhicule automobile ; dans le cas des latéraux automobiles, la réflexion est faible et pour tous, la tenue à l'abrasion et à l'attaque en milieu humide sont très bonnes. De tels vitrages peuvent trouver des applications multiples aussi bien comme vitrage bâtiment que comme vitrage automobile.

**Revendications**

1. Vitrage de protection solaire à base de verre silico-sodo-calcique recouvert d'au moins une couche mince et au plus de deux couches minces **caractérisé en ce que** la couche au contact du verre est à base de tantale métallique avec au maximum une épaisseur de 30 nm **et en ce que**, lorsqu'elle est présente, l'autre couche a une épaisseur inférieure à 40 nm et est constituée d'au moins un oxyde métallique.

2. Vitrage selon la revendication 1, **caractérisé en ce que** le dépôt de la ou des couches est effectué sous vide.

3. Vitrage selon la revendication 2, **caractérisé en ce que** la technique de dépôt est la pulvérisation cathodique à confinement magnétique du plasma.

4. Vitrage selon l'une des revendications précédentes, **caractérisé en ce que** la couche à base de tantale est seule et que son épaisseur est comprise entre 2 et 30 nm.

5. Vitrage selon la revendication 4 **caractérisé en ce que** l'épaisseur de la couche est comprise entre 4,5 et 6,5 nm.

6. Vitrage selon la revendication 4 **caractérisé en ce que** l'épaisseur de la couche est comprise entre 22 et 28 nm.

7. Vitrage selon l'une des revendications précédentes, **caractérisé en ce que** la couche à base de tantale est recouverte d'une couche d'oxyde d'un ou de plusieurs des métaux du groupe comprenant l'étain, l'indium, le zinc, l'antimoine, le cadmium et le tantale.

8. Vitrage selon la revendication 7, **caractérisé en ce que** l'épaisseur de l'oxyde est supérieure à 10 nm.

9. Vitrage selon la revendication 7 ou la revendication 8, **caractérisé en ce que** l'épaisseur de la couche de tantale est de 5 nm.

10. Vitrage selon la revendication 7 ou la revendication 8, **caractérisé en ce que** l'épaisseur de la couche de tantale est de 25 nm.

11. Vitrage selon la revendication 9 ou la revendication 10, **caractérisé en ce que** l'épaisseur de la couche d'oxyde est de 12 nm.

12. Vitrage selon l'une des revendications précédentes, **caractérisé en ce que** le verre support est coloré.

13. Vitrage selon la revendication 12, **caractérisé en ce que** le verre support est du type dit TSA ou TSA ++ ou TFA.

14. Vitrage selon l'une des revendications 5, 7 à 9 ou 11 à 13 précédentes, **caractérisé en ce que** sa transmission lumineuse est comprise entre 0,30 et 0,75.

15. Vitrage selon l'une des revendications 6 à 8 ou 10 à 13 **caractérisé en ce que** sa transmission lumineuse est inférieure à 0,10.

16. Vitrage selon la revendication 13 et la revendication 14, **caractérisé en ce que** le rapport de la transmission énergétique à la transmission lumineuse est inférieur à 0,70.

17. Vitrage selon la revendication 14 ou 16, **caractérisé en ce que** la réflexion lumineuse au travers du verre est au maximum de 0,10.

**Claims**

1. Solar protection glazing based upon silico-sodo-calcic glass covered with at least one thin film and at most two this films, characterized in that the film in contact with the glass is based upon metallic tantalum with, at most, a thickness of 30 nm and in that the other film, if present, has a thickness of less than 40 nm and is constituted of at least one metallic oxide.

2. Glazing according to claim 1, characterized in that the deposition of the film or films is carried out under vacuum.

3. Glazing according to claim 2, characterized in that the deposition technique is catholic sputtering with magnetic confinement of the plasma.

4. Glazing according to one of the preceding claims, characterized in that the tantalum-based film is the only film present and that its thickness is between 2 and 30 nm;

5. Glazing according to claim 4, characterized in that the thickness of the film is from 4.5 to 6.5 nm.

6. Glazing according to claim 4, characterized in that the thickness of the film is from 22 to 28 nm.

7. Glazing according to one of the preceding claims, characterized in that the tantalum-based film is covered with a film of oxide of one or more of the metals of the group comprising tin, indium, zinc, antimony, cadmium and tantalum.

8. Glazing according to claim 7, characterized in that the thickness of the oxide exceeds 10 nm.

9. Glazing according to claim 7 or 8, characterized in that the thickness of the tantalum film is about 5 nm.

10. Glazing according to claim 7 or 8, characterized in that the thickness of the tantalum film is about 25 nm.

11. Glazing according to claim 9 or 10, characterized in that the thickness of the oxide film is about 12 nm.

12. Glazing according to one of the preceding claims, characterized in that the support glass is coloured.

13. Glazing according to claim 12, characterized in that the support glass is of the type known as TSA or TSA$^{++}$ or TFA.

14. Glazing according to one of the preceding claims 5, 7 to 9 or 11 to 13, characterized in that its light transmission is from 0.30 to 0.75.

15. Glazing according to one of claims 6 to 8 or 10 to 13, characterized in that its light transmission is less than 0.10.

16. Glazing according to claim 13 and 14, characterized in that the ratio of the energy transmission to the light transmission is less than 0.70.

17. Glazing according to claim 14 or 16, characterized in that the light reflection through the glass is, at maximum, 0.10.

**Patentansprüche**

1. Sonnenschutzverglasung auf der Grundlage von Kalk-Natron-Silicat-Glas, das mit wenigstens einer dünnen Schicht und höchstens zwei dünnen Schichten überzogen ist, **dadurch gekennzeichnet, daß** die im Kontakt mit dem Glas befindliche Schicht eine Dicke von höchstens 30 nm und metallisches Tantal zur Grundlage hat **und daß** die andere Schicht, falls sie vorhanden ist, eine Dicke von unter 40 nm besitzt und aus wenigstens einem Metalloxid besteht.

2. Verglasung nach Anspruch 1, **dadurch gekennzeichnet, daß** die Schicht/en unter Vakuum aufgebracht wird/werden.

3. Verglasung nach Anspruch 2, **dadurch gekennzeichnet, daß** das Beschichtungsverfahren die Kathodenzerstäubung mit magnetischem Plasmaeinschluß ist.

4. Verglasung nach einem der vorhergehenden Ansprüche, **dadurch gekennzeichnet, daß** nur eine Schicht auf Tantalgrundlage vorhanden ist, deren Dicke 2 bis 30 nm beträgt.

5. Verglasung nach Anspruch 4, **dadurch gekennzeichnet, daß** die Schichtdicke 4,5 bis 6,5 nm beträgt.

6. Verglasung nach Anspruch 4, **dadurch gekennzeichnet, daß** die Schichtdicke 22 bis 28 nm beträgt.

7. Verglasung nach einem der vorhergehenden Ansprüche, **dadurch gekennzeichnet, daß** die Schicht auf Tantalgrundlage mit einer Schicht aus einem Oxid eines oder mehrerer Metalle aus der Zinn, Indium, Zink, Antimon, Cadmium und Tantal umfassenden Gruppe überzogen ist.

8. Verglasung nach Anspruch 7, **dadurch gekennzeichnet, daß** die Dicke des Oxids über 10 nm liegt.

9. Verglasung nach Anspruch 7 oder 8, **dadurch gekennzeichnet, daß** die Dicke der Tantalschicht 5 nm beträgt.

10. Verglasung nach Anspruch 7 oder 8, **dadurch gekennzeichnet, daß** die Dicke der Tantalschicht 25 nm beträgt.

**11.** Verglasung nach Anspruch 9 oder 10, **dadurch gekennzeichnet, daß** die Dicke der Oxidschicht 12 nm beträgt.

**12.** Verglasung nach einem der vorhergehenden Ansprüche, **dadurch gekennzeichnet, daß** das Trägerglas ein Farbglas ist.

**13.** Verglasung nach Anspruch 12, **dadurch gekennzeichnet, daß** das Trägerglas vom Typ TSA bzw. TSA$^{++}$ oder TFA ist.

**14.** Verglasung nach einem der Ansprüche 5, 7 bis 9 oder 11 bis 13, **dadurch gekennzeichnet, daß** ihr Lichttransmissionsgrad 0,30 bis 0,75 beträgt.

**15.** Verglasung nach einem der Ansprüche 6 bis 8 oder 10 bis 13, **dadurch gekennzeichnet, daß** ihr Lichttransmissionsgrad unter 0,10 liegt.

**16.** Verglasung nach Anspruch 13 und 14, **dadurch gekennzeichnet, daß** das Verhältnis von Energiedurchgangsgrad zu Lichttransmissionsgrad unter 0,70 liegt.

**17.** Verglasung nach Anspruch 14 oder 16, **dadurch gekennzeichnet, daß** der Lichtreflexionsgrad durch das Glas höchstens 0,10 beträgt.

*Fig. 1*

*Fig. 2*